# EUROPEAN PATENT APPLICATION

(11) **EP 4 407 656 A1**
(43) Date of publication of application: **31.07.2024**
(21) Application number: 23153656.6
(22) Date of filing: 27.01.2023
(51) Int. Cl.: H01L 21/02

(54) **A SEMICONDUCTOR STRUCTURE**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

A semiconductor structure (1), comprising:
a substrate (2);
a base layer (10), the base layer (10) comprising an AlGaN layer, the base layer (10) being arranged above the substrate (2);
at least one group of layers (20), the at least one group of layers (20) being arranged above the base layer (10), wherein each of the at least one group of layers (20) comprises:
a first layer (21), the first layer (21) being a layer of InGaN and comprising quantum dots (24);
a second layer (22), the second layer (22) being a layer of InGaN, the second layer (22) being arranged on and above the first layer (21), wherein the second layer (22) laterally encloses the quantum dots (24) of the first layer (21), wherein a material composition of the InGaN of the second layer (22) is different from a material composition of the InGaN of the first layer (21).

## Description

### TECHNICAL FIELD

The present inventive concept relates, in general, to a semiconductor structure.

### BACKGROUND

Nitride semiconductors, i.e. compounds of elements from the third group of the periodic table of elements and nitrogen, provide numerous advantages compared to silicon. Devices based thereon provide promising candidates for replacing silicon-based electronic devices. For example, such devices may offer faster switching speeds, increased electron mobility, lower resistances, larger breakdown voltages, etc.

However, nitride semiconductors often comprise dislocations. Various methods to reduce such dislocations have been developed but further improvements are possible.

### SUMMARY

It is an objective of the present inventive concept to provide a semiconductor structure facilitating epitaxial growth of high-quality nitride semiconductors. It is a further objective of the present inventive concept to facilitate high-quality electronic devices such as fast, reliable, and cheap electronic devices.

These and other objectives of the inventive concept are at least partly met by the invention as defined in the independent claims. Preferred embodiments are set out in the dependent claims.

In this text abbreviations of the natural elements will be used in accordance with the periodic table. For example, Al means aluminum, Ga means gallium, As means arsenic, Mg means magnesium, O means oxygen, Si means silicon.

Compounds comprising a plurality of elements may be referred to herein by combinations of element symbols. E.g. gallium nitride may be referred to as GaN and aluminium nitride may be referred to as AIN. Some compounds may be provided with ratios of their relative elemental composition. E.g. aluminium gallium nitride may be referred to as AlₓGa₁₋ₓN wherein x is a variable that may assume values from 0 to 1. The subscripted affix indicates the relative ratio of the preceding element. If e.g. x=0.5, or Al_{0.5}Ga_{0.5}N, it may be understood that regarding the group III atomic content 50% is aluminium and 50% is gallium while regarding the group V atomic content 100% is nitrogen. Just AlGaN, without the ratios, may alternatively refer aluminium gallium nitride of varying compositions. Group III and group V herein refer to group III and group V of the periodic table of elements, respectively.

According to a first aspect, there is provided a semiconductor structure, comprising:
a substrate;
a base layer, the base layer comprising an AlGaN layer, the base layer being arranged above the substrate;
at least one group of layers, the at least one group of layers being arranged above the base layer, wherein each of the at least one group of layers comprises:
   a first layer, the first layer being a layer of InGaN and comprising quantum dots;
   a second layer, the second layer being a layer of InGaN, the second layer being arranged on and above the first layer, wherein the second layer laterally encloses the quantum dots of the first layer, wherein a material composition of the InGaN of the second layer is different from a material composition of the InGaN of the first layer.

It is a realization that quantum dots may encapsulate dislocations during epitaxial growth of nitride semiconductors. Thus, the quantum dots (QDs) may prevent or reduce spreading of dislocations above the second layer. The quantum dots may prevent or reduce spreading of dislocations in a direction orthogonal to the substrate above the second layer. In the following, the direction orthogonal to the substrate, i.e. the growth direction, will be called the vertical direction. Further, directions parallel to the substrate will be called lateral directions.

The substrate may be a non-nitride substrate such as a silicon substrate, a sapphire substrate, or a silicon carbide substrate. It may be advantageous to grow nitride semiconductors on such non-nitride substrates since substrates of nitride semiconductor material may be hard to produce, and/or expensive to produce, or in some cases impossible to produce. However, the use of a non-nitride substrate may cause dislocations, e.g. dislocations in the base layer. Such dislocations may be prevented from spreading vertically and thereby prevented from reaching device layers above the second layer.

A silicon substrate may be particularly advantageous as silicon substrates are inexpensive and compatible with common semiconductor processing methods. In particular, the silicon substrate may have a top surface with a Miller index of {111}.

It should be understood that the invention provides advantages also in the case where the substrate is a nitride substrate, e.g. a GaN substrate. Dislocations may form also when using a nitride substrate, in which case it is advantageous to encapsulate the dislocations.

The base layer is arranged above the substrate, e.g. directly above the substrate. The base layer may be an AlGaN layer of any composition, from AIN to GaN. A base layer comprising an AlN layer is advantageous, e.g. an AlN layer directly above the substrate, e.g. directly above a silicon substrate. For example, a sputtered AlN layer directly above a silicon substrate is advantageous as the defect density at the interface between sputtered AlN and silicone may be low.

The at least one group of layers is arranged above the base layer, e.g. directly above the base layer. Thus, the first layer is arranged above the base layer, e.g. directly above the base layer. The at least one group of layers may comprise more layers than the first and second layer. For example, the first layer may be an interlayer, e.g. between a zeroth layer and the second layer.

The quantum dots of the first layer may have a height, i.e. a size in the vertical direction, of 1-20 nm. The quantum dots of the first layer may have a width, i.e. a size in a lateral direction, of 10-20 nm. The quantum dots of the first layer may be shaped as pyramids, truncated pyramids, or domes. The side facets of the quantum dots may form inclined planes, such as planes having an angle to the lateral directions.

The first layer may have a volume corresponding to 2-10 monolayers, e.g. 8-10 monolayers. For example, when growing 8-10 monolayers lattice mismatched to a layer below, said monolayers may rearrange in a self-assembly process to form quantum dots.

In some embodiments of the invention the quantum dots form islands that may be truncated pyramids, pyramids that comprises an apex, spherical, circular disk or ellipse-shaped disk. The quantum dots of the first layer may be quantum dots that form in high densities by self-assembly. The quantum dots of the first layer may e.g. be Stranski-Krastanov quantum dots. Thus, the first layer may, in addition to the quantum dots, comprise a wetting layer. Alternatively, the quantum dots of the first layer may be Volmer-Weber quantum dots. Self-assembled quantum dots may provide a high quantum dot density and/or small quantum dots. This may be beneficial for providing efficient encapsulation of the dislocations.

The second layer is arranged above the first layer, e.g. directly above the first layer, and the second layer laterally encloses the quantum dots of the first layer. Thus, the quantum dots of the first layer may be partially or fully embedded in the second layer.

During epitaxial growth of the second layer, dislocations may be encapsulated. For example, dislocations propagating vertically may be encapsulated. One mechanism for encapsulation may be the development of the side facets of the quantum dots. The development of these side facets may cause dislocations to bend towards a lateral direction. This may happen at least under some growth conditions, as understood from this application as a whole.

The above is applicable also when the base layer comprises pillars or nanopillars. For example, during epitaxial growth of the second layer, dislocations propagating vertically on top and over the pillars or nanopillars may be encapsulated whereas dislocation free areas formed between the pillars continue to grow dislocation free. As mentioned, one mechanism for encapsulation may be the development of the side facets of the quantum dots causing dislocations to bend towards a lateral direction.

In a first example, a dislocation propagating in the vertical direction, e.g. from the base layer and through a quantum dot of the first layer, may when the second layer is grown on the side facets of the quantum dot bend into the lateral direction. Thus, the dislocation may be encapsulated in the second layer and prevented from propagating further in the vertical direction.

In a second example, a dislocation created when the first layer is overgrown with the second layer may also be forced to propagate in a lateral direction. For example, forced into the lateral direction by the development of the side facets of the quantum dot.

Encapsulation of dislocations may additionally, or alternatively, be promoted by dislocations coalescing. For example, a dislocation originating in a first quantum dot may coalesce with a dislocation originating in a second quantum dot. Thus, the two dislocations may be terminated and prevented from propagating further.

Consequently, above the quantum dots of the first layer there is a high quality of the semiconductor material, e.g. a high crystalline quality. For example, parts of the second layer above the quantum dots of the first layer has a high quality and/or layers above the second layer have a high quality.

Thus, the second layer, or a layer above the second layer, may be used for devices, e.g. transistors or light emitting diodes. Consequently, the second layer, or a layer above the second layer, may comprise parts of a transistor, e.g. a source, a body, or a drain of a transistor. However, it should be understood that the semiconductor structure may have advantages even if it does not, yet, comprise part of a transistor or light emitting diode. For example, a semiconductor structure may be sold as a template, e.g. an epi-ready template, on which further epitaxial growth may be performed. Such a template may facilitate production of high-quality devices, e.g. high-quality transistors or light emitting diodes.

As an example, the semiconductor structure may comprise or facilitate GaN complementary-metal-oxide-semiconductor (CMOS) devices or More-than-Moore CMOS devices. Accordingly, the semiconductor structure is beneficial for using GaN in very-large-scale-integration (VLSI) device fabrication.

As another example, the semiconductor structure may comprise or facilitate growth of a heterojunction above the quantum dots of the first layer. The heterojunction may be an interface between two different semiconductor materials. The heterojunction may be configured to form a two-dimensional electron gas (2DEG). Such a heterojunction may be used to make a high-electron-mobility transistor (HEMT). Such a heterojunction may be very sensitive to dislocations and therefore it may be particularly advantageous with a first layer comprising quantum dots below the heterojunction.

The quantum dots may have further advantages, in addition to encapsulating dislocations. For example, it is a realization that quantum dots may aid charge carrier recombination and thereby improve devices such as transistors above the quantum dots. For example, a HEMT may be improved by quantum dots at a distance, e.g. at least 1 micrometer, from the 2DEG. Such quantum dots may be configured to have a bandgap of 1.6 -1.8 eV. This may be in the middle of the bandgap of surrounding material. The quantum dots may be configured as recombination centers. This may prevent emission of light in a 'non-radiative' form by high p doping. In other words, the quantum dots may be resistive and/or non-conductive for electrons.

It is thus an object of the invention that the quantum dots also may be provided as recombination centers by quantum dots as artificial atoms. Currently, recombination centers for high-frequency GaN HEMT power amplifiers (PAs) are provided by iron atoms that act as an electron trap states and acceptor for electrons close to the conduction band edge. Iron dopant in the crystal structure of GaN may create gallium vacancy states as deep donor states 0.70 eV above the valence band. By the quantum dots having a band gap in the middle of the band gap of GaN, quantum dots present states that may act as both as acceptor and a donor.

Hence, it is preferred that the quantum dot comprises InGaN with a lower band gap than that of GaN. Due to the miscibility gap of InN and GaN, it is hence a preferred embodiment of the invention that the indium concentration is in the range of 5-20% or in the range of 5-10%.

Such a semiconductor structure may facilitate high switching frequencies of the HEMT. GaN HEMT devices have a short ON-time by the low ON-resistance. However, at high frequencies the device may still considerably slow OFF times preventing high-frequency application. By facilitating recombination of electrons and hole charge carriers at the quantum dots that can be optimized by band engineering, the inventor has realized that frequencies on the order of 24-56 GHz which is suitable for the fifth-generation technology standard for broadband cellular networks (5G) may be provided. Such would also be beneficial to provide a energy efficient sub-6 GHz GaN HEMT-on-Silicon device as an alternative to silicon LDMOS technology.

The at least one group of layers may comprise a plurality of groups of layers. Thus, the semiconductor structure may comprise a plurality of layers comprising quantum dots. For example, the semiconductor structure may comprise:
a first group of layers above the base layer, the first group of layers comprising a first layer and a second layer, the first layer of the first group of layers being a layer of InGaN and comprising quantum dots, the second layer of the first group of layers being a layer of InGaN arranged above the first layer of the first group of layers, wherein the second layer of the first group of layers laterally encloses the quantum dots of the first layer of the first group of layers; and
a second group of layers above the first group of layers, the second group of layers comprising a first layer and a second layer, the first layer of the second group of layers being a layer of InGaN and comprising quantum dots, the second layer of the second group of layers being a layer of InGaN arranged above the first layer of the first group of layers, wherein the second layer of the second group of layers laterally encloses the quantum dots of the first layer of the first group of layers.

By using several groups of layers of self-assembled quantum dots, dislocations may be encapsulated even more efficiently than with one single group of layers. For example, a dislocation which has propagated through the first group of layers, e.g. by passing between quantum dots, may be encapsulated by the second group of layers.

It should be understood that the groups of layers of the plurality of groups of layers may not necessarily be identical. They may e.g. differ in size or composition of the quantum dots.

The semiconductor structure may be configured such that, for at least one of the at least one group of layers:
an Indium content of the InGaN of the first layer is higher than an Indium content of the InGaN of the second layer.

Thus, the first layer may comprise material with a larger lattice constant than the second layer. Thus, the first layer may comprise material with a smaller bandgap than the second layer. This may provide efficient encapsulation of the dislocations.

The semiconductor structure may be configured such that, for at least one of the at least one group of layers:
a material composition of the InGaN of the first layer is InₓGa₁₋ₓN, wherein x is a number in the range 0 to 0.2 or 0.2-0.4. It is a realization that such a composition provides particularly efficient encapsulation of the dislocations.

To exemplify, the semiconductor structure may be (from bottom to top:
substrate / AlGaN / InGaN / InGaN-QD / AlGaN, wherein the InGaN-QDs have an Indium composition up to 50%, i.e. x≤0.5.

To exemplify further, the semiconductor structure may be (from bottom to top:
Silicon substrate / AlGaN / InGaN / In_{0.30}Ga_{0.70}N-QD / AlGaN

The semiconductor structure may be configured such that, for at least one of the at least one group of layers:
a density of the quantum dots of the first layer is between 10⁹ cm⁻² and 10¹³ cm⁻².

The semiconductor structure may be configured such that, for at least one of the at least one group of layers:
a density of the quantum dots of the first layer is at least 10¹⁰ cm⁻².

It is a realization that the above-mentioned densities of quantum dots provide particularly efficient encapsulation of the dislocations. A high density of quantum dots may be advantageous to provide efficient encapsulation of already formed dislocations. At the same time, a too high density of quantum dots may form new dislocations. In this sense, it may be advantageous with a density of the quantum dots in the range of 10⁹ cm⁻² and 10¹³ cm⁻². However, it should be understood that in principle the density of the quantum dots may be higher than 10¹³ cm⁻².

It should be understood that the density of the quantum dots refers to a number of quantum dots per unit area within a plane comprising the quantum dots.

The semiconductor structure may be configured such that the quantum dot layer (i.e. the first layer) is lattice mismatched to the layer below or above.

In a first example of lattice mismatch, consider the situation where the quantum dot layer (i.e. the first layer) is lattice mismatched to the layer below:

The semiconductor structure may be configured such that, for at least one of the at least one group of layers:
a lattice constant of material in the first layer is at least 0.5 % larger than a lattice constant of material in a layer directly below said first layer at room temperature.

Thus, the first layer may be lattice mismatched to a layer directly below said first layer. The lattice mismatch may be at least 0.5%. Such lattice mismatch may be a driving force for formation of self-assembled quantum dots. Thus, the quantum dots of the first layer may be formed due to the lattice mismatch.

In a second example of lattice mismatch, consider the situation where the quantum dot layer (i.e. the first layer) is lattice mismatched to the layer above:

The semiconductor structure may be configured such that, for at least one of the at least one group of layers,
a lattice constant of material in the first layer is at least 0.5 % larger than a lattice constant of material in the second layer at room temperature.

Thus, the first layer may be lattice mismatched to the second layer. The lattice mismatch may be at least 0.5%.

It should be understood that when two crystalline materials are combined, one or both materials may be strained and adapt at least partially to the lattice constant of the other material. It should therefore be understood that the above-mentioned lattice constants are nominal lattice constants, i.e. lattice constants of the materials when not strained. In other words, the lattice constants are unstrained lattice constants.

The semiconductor structure may be configured such that the base layer comprises:
a primary layer, the primary layer being a layer of semiconductor material, the primary layer comprising pillars extending in a direction perpendicular to the substrate;
a secondary layer, the secondary layer being a layer of semiconductor material, wherein the secondary layer is configured to laterally enclose the pillars of the primary layer.

The primary layer may comprise AlGaN, e.g. AlN. The primary layer may comprise sputtered AlN. The secondary layer may comprise AlₓGa₁₋ₓN, wherein 0≤x≤0.95. The secondary layer may comprise AlₓGa₁₋ₓN, wherein 0≤x≤0.40. The secondary layer may comprise AlₓGa₁₋ₓN, wherein 0≤x≤0.20. In a preferred embodiment of the secondary layer, the secondary layer is GaN. The pillars may have a diameter in the of range of 1-100 nm, preferably in the range of 5-50 nm, more preferably in the range of 10-30 nm. The pillars may be nanowires.

The secondary layer may grow as shells on the pillars of the primary layer, thereby enclosing the pillars. A semiconductor layer structure comprising pillars that are enclosed by another layer may promote encapsulation and accumulation of dislocations along the shell of the pillars and hence reduce the amount of material defects and cracks that propagate to the surface of the semiconductor layer structure.

Dislocations may be especially prone to propagate laterally between the pillars, e.g. by epitaxially growing along the length of nanowires such that the shells from different nanowires coalesce to form a common thin-film. As the dislocations laterally bend laterally, the dislocations may be prevented from propagating further. The quantum dots or the third layer grown on said second layer may be silicon doped.

As an example of the benefits of a base layer comprising the above mentioned primary and secondary layers, consider the following:
A primary layer may be deposited by sputtering of AlN (or AlGaN), e.g. on a silicon substrate, e.g. on a silicon substrate with a top surface having a Miller index of {111}. Sputtered AlN is not necessarily single crystalline and grain boundaries may form, at least under some growth conditions. Vertical pillars may then be etched from the AlN layer and may therefore comprise the grain boundaries. When the pillars are laterally overgrown, by depositing the secondary layer, Al(x)Ga(1-x)N growth may be seeded by these grain boundaries. The dislocations may, at least under some growth conditions, be especially prone to propagate laterally between pillars in the M-direction of the wurtzite crystal structure and therefore propagate laterally (the M-direction being a lateral direction as a consequence of the substrate being a Si {111} substrate). Thus, dislocations may coalesce laterally with dislocations from other nanowire structures to form a dislocation free thin-film. Thereby, defects may, at least to some extent, be filtered out such that the amount of defects and cracks that propagate to the surface of the semiconductor layer structure is reduced. When the pillar shells unite into a common thin film laterally that then begins to grow in the C-direction, dislocations may be trapped and prevented from spreading in the C-direction (i.e. prevented from spreading vertically). Thus, by forming the dislocations in the first place, strain arising from growth on a silicon substrate may be accommodated but at least some of the dislocations may be encapsulated and prevented from spreading further into the vertical direction. Dislocations which escape the base layer above the nanopillars may then be encapsulated during growth of the group of layers comprising the quantum dots. Additionally, or alternatively, other types of dislocations, e.g. dislocations associated with the unification of the pillar shells between and above nanopillars, may be encapsulated during growth of the group of layers comprising the quantum dots.

It is a realization that the combination of pillars and quantum dots may be particularly useful for encapsulating dislocations that are not filtered to the immediate height of the nanopillars. Many dislocations may be encapsulated already in the base layer. Dislocations that escape the base layer and propagate into the at least one group of layers may be encapsulated there by the quantum dots. The pillars and the quantum dots may complement each other and encapsulate different types of dislocations.

According to a second aspect there is provided a method for producing the semiconductor structure of the first aspect, the method comprising:
providing the substrate;
forming the base layer above the substrate;
forming the at least one group of layers above the base layer by forming the first layer and forming the second layer,
wherein forming the at least one group of layers comprises, for at least one of the at least one group of layers, forming the quantum dots of the first layer by self-assembly.

Forming the layers of the semiconductor structure may be done by any kind of epitaxial growth, e.g. by metal-organic vapor phase epitaxy (MOVPE) or molecular beam epitaxy (MBE).

As previously mentioned, the quantum dots of the first layer may be self-assembled quantum dots. The quantum dots of the first layer may e.g. be Stranski-Krastanov quantum dots. Thus, the first layer may in addition to the quantum dots comprise a wetting layer. Alternatively, the quantum dots of the first layer may be Volmer-Weber quantum dots. Self-assembled quantum dots may provide a high quantum dot density and/or small quantum dots. This may be beneficial for providing efficient encapsulation of the dislocations. Further, a self-assembly process may be advantageous in combination with a patterning process. For example, if quantum dots formed by self-assembly are combined with a base layer comprising pillars formed by patterning, e.g. lithographic patterning, the self-assembled process may e.g. make up for inhomogeneities in the patterning process.

According to the above, the self-assembly formation of the quantum dots may be driven by a lattice mismatch between the first and second layer.

Forming the at least one group of layers may comprise, for at least one of the at least one group of layers: forming the quantum dots of the first layer by Stranski-Krastanov growth.

Stranski-Krastanov growth may be a growth mode that provides a suitable quantum dot size and/or quantum dot density.

Stranski-Krastanov growth may be a growth mode that is suitable for forming quantum dots which can promote encapsulation of dislocations propagating from below without forming a large number of new dislocations. Thus, the net effect of such quantum dots may be a reduction of dislocations propagating further above the first layer comprising the quantum dots.

Forming the at least one group of layers may comprise, for at least one of the at least one group of layers:
interrupting a gas flow for at least 5 seconds between forming the first layer and forming the second layer, wherein the gas flow is a gas flow comprising nitrogen.

For example, the gas flow may be interrupted for 10-20 seconds between forming the first layer and forming the second layer. The gas flow comprising nitrogen may be e.g. a gas flow comprising nitrogen gas and/or a gas flow comprising ammonia.

Such an interrupt may provide a suitable quantum dot size and/or quantum dot density. For example, the first layer may be formed by growing 2-10 monolayers, e.g. 8-10 monolayers, planarly. Interrupting a gas flow comprising nitrogen may be seen as stopping a group V supply. As an alternative, a group III supply may be interrupted, such as interrupting the flow of group III precursor gas, e.g. interrupting trimethyl gallium and/or or triethyl gallium in a nitrogen gas or ammonia gas atmosphere. Group III and group V herein refers to group III and group V of the periodic table of elements.

An interrupt may stop further growth. During the interrupt the planar monolayers may rearrange to form quantum dots, e.g. rearrange to form a wetting layer and quantum dots.

Forming the at least one group of layers may comprise, for at least one of the at least one group of layers:
ending layer formation of the first layer based on a photoluminescence signal from the quantum dots of the first layer.

The photoluminescence spectrum may depend on the quantum dot size and/or quantum dot density. Thus, photoluminescence may be used to fine-tune the quantum dot size and/or quantum dot density.

As a first example: when the photoluminescence spectrum indicates that the quantum dots have reached a threshold size, the formation of the first layer may be ended. The threshold size may be a threshold indicating the quantum dots having a height of 1-20 nm and/or the quantum dots having a width of 10-20 nm.

As a second example: when the photoluminescence spectrum indicates that the quantum dots have reached a threshold density, the formation of the first layer may be ended. The threshold density may indicate a density of the quantum dots being above 10¹⁰ cm⁻² or a density of the quantum dots being between 10⁹ cm⁻² and 10¹³ cm⁻².

Forming the base layer may comprise:
forming a primary layer, the primary layer being a layer of semiconductor material, the primary layer comprising pillars extending in a direction perpendicular to the substrate;
forming a secondary layer, the secondary layer being a layer of semiconductor material, wherein the secondary layer is configured to laterally enclose the pillars of the primary layer;
wherein said primary layer is formed in an atmosphere comprising hydrogen and nitrogen; and/or wherein said secondary layer is formed in an atmosphere comprising nitrogen.

The base layer may be an interlayer of AlN or AlGaN. It is a preferred embodiment of the invention to use the strain of InGaN growth on an interlayer of AlN or AlGaN as the driving force for quantum dot formation. Reducing dislocations at these interfaces may alleviate with cracking of GaN HEMT epiwafers. The interlayer may have a thickness of 10-30 nm that is grown until a growth interrupt for 5-20 seconds upon which quantum dots are formed. The base layer being an interlayer may herein be construed as the base layer being a layer between the quantum dot layer (the first layer) and another layer.

Said primary layer may be formed in an atmosphere comprising hydrogen and nitrogen with a hydrogen to nitrogen molar ratio between 2 to 1 (i.e. the hydrogen amount being twice the nitrogen amount) and 1 to 2 (i.e. the nitrogen amount being twice the hydrogen amount). In particular, said primary layer may be formed in an atmosphere comprising hydrogen and nitrogen with a hydrogen to nitrogen molar ratio of 1 to 1, i.e. an equal amount of hydrogen and nitrogen.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a cross-sectional view of a semiconductor structure.
Fig. 2 is a cross-sectional view of a semiconductor structure.
Fig. 3 is a cross-sectional view of a semiconductor structure.
Fig. 4 is a cross-sectional view of a semiconductor structure.
Fig. 5 is a cross-sectional view of a semiconductor structure.
Fig. 6 is a cross-sectional view of a semiconductor structure.
Fig. 7 is a top view of a semiconductor structure.
Fig. 8 is a flowchart of a method
Fig. 9 is a flowchart of a method
Fig. 10 is a band diagram
Fig. 11 is a band diagram

### DETAILED DESCRIPTION

In cooperation with attached drawings, the technical contents and detailed description of the present invention are described according to preferable embodiments, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

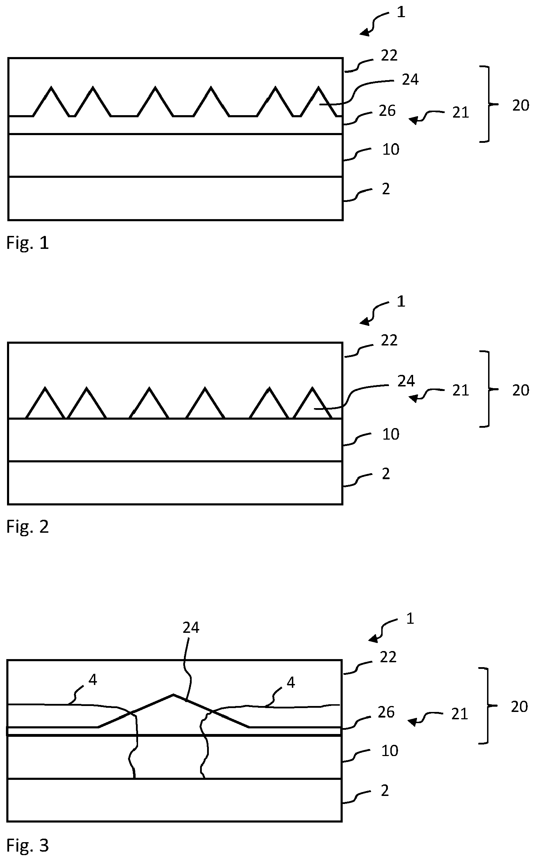

Figs 1-6 illustrate semiconductor structures 1 according to the invention. The semiconductor structures 1 are seen in cross-sectional view. Each semiconductor structure 1 comprises:
a substrate 2;
a base layer 10, the base layer 10 comprising an AlGaN layer, the base layer 10 being arranged above the substrate 2;
at least one group of layers 20, the at least one group of layers 20 being arranged above the base layer 10, wherein each of the at least one group of layers 20 comprises:
   a first layer 21, the first layer 21 being a layer of InGaN and comprising quantum dots 24;
   a second layer 22, the second layer 22 being a layer of InGaN, the second layer 22 being arranged above the first layer 21, wherein the second layer 22 laterally encloses the quantum dots 24 of the first layer 21,
wherein a material composition of the InGaN of the second layer 22 is different from a material composition of the InGaN of the first layer 21.

The quantum dots 24 of the first layer 21 may be self-assembled quantum dots. The quantum dots 24 of the first layer 21 may e.g. be Stranski-Krastanov quantum dots. The first layer 21 may in addition to the quantum dots 24 comprise a wetting layer 26, as illustrated in Fig. 1. Alternatively, the quantum dots 24 of the first layer 21 may be Volmer-Weber quantum dots 24. Volmer-Weber quantum dots 24 may be formed directly on the base layer 10, without any wetting layer 26, as illustrated in Fig. 2. Accordingly, there may be gaps between the quantum dots 24 where a layer below the first layer 21 (in Fig. 2 the base layer 10) is in contact with the second layer 22.

Fig. 3 illustrates how a quantum dot 24 may cause dislocations 4 to bend towards a lateral direction. The figure illustrates two dislocations 4 propagating in the vertical direction, from the interface between the substrate 2 and the base layer 10, through the base layer 10, and through a quantum dot 24 of the first layer 21. Each illustrated dislocation 4 then bend into the lateral direction in the second layer 22.

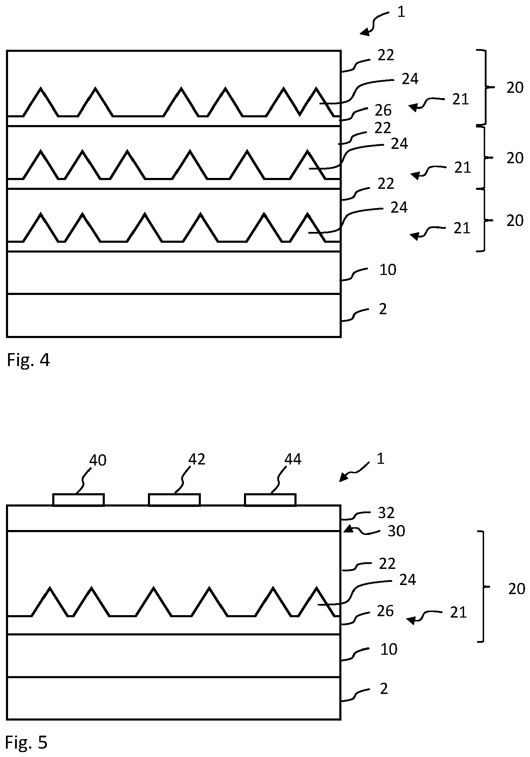

Fig. 4 illustrates a semiconductor structure 1 comprising a plurality of groups of layers 20, in this case three groups of layers 20. Each group of layers 20 herein comprises a first 21 and a second 22 layer. The quantum dots of the different groups of layers do not necessarily need to align. Thus, a quantum dot of a first group of layers may be arranged at a lateral position at which there is no quantum dot in a second group of layers.

By using several groups of layers, dislocations may be encapsulated efficiently. A dislocation which has propagated through the first group of layers, e.g. by passing between quantum dots, may be encapsulated by the second group of layers.

Fig. 5 illustrates a semiconductor structure 1 comprising a heterojunction 30 above the quantum dots 24 of the first layer 21. The heterojunction 30 is an interface between two different semiconductor materials. In Fig. 5 the heterojunction 30 is an interface between the second layer 22 and a barrier layer 32. The barrier layer 32 may herein have a larger bandgap than the layer below. In this case, the barrier layer 32 may have a larger bandgap than the second layer 22. The barrier layer 32 may be an AlGaN layer and the layer below, in this case the second layer 22, may be a GaN layer.

The heterojunction 30 may be configured to form a 2DEG. Such a heterojunction 30 may be used to make a HEMT. Fig. 5 may be seen as an example of such a HEMT, wherein a source electrode 40, a gate electrode 42, and a drain electrode 44 are arranged on a surface of the semiconductor structure 1 above the heterojunction, in this case on top of the barrier material.

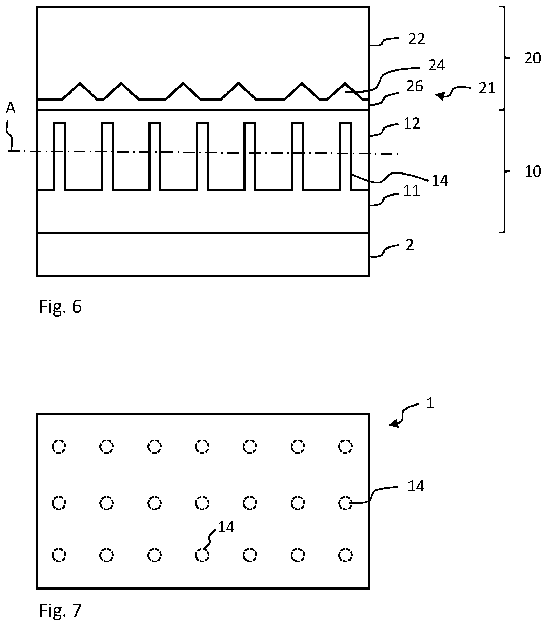

Fig. 6 is a cross-sectional view from the side of a semiconductor structure 1 wherein the base layer 10 comprises:
a primary layer 11, the primary layer 11 being a layer of semiconductor material, the primary layer 11 comprising pillars 14 extending in a direction perpendicular to the substrate 2;
a secondary layer 12, the secondary layer 12 being a layer of semiconductor material, wherein the secondary layer 12 is configured to laterally enclose the pillars 14 of the primary layer 11. Fig. 7 is a cross-sectional view from the top of the same semiconductor structure 1, the cross-section being along line A in Fig. 6. The pillars 14 may be arranged in an array, as seen in the Fig. 7 cross-sectional view from the top. Alternatively, the pillars 14 may be distributed randomly. It should be understood that during the maskless overgrowth of the pillars 14 by GaN, dislocations may propagate vertically whereas dislocations becomes filtered to from a dislocation free layer immediately above the height of the pillars. In some embodiments the quantum dots may be provided as a dislocation filter for the vertically propagating dislocations on top of the nanopillars. In other embodiments, one or more layers of quantum dots may be provided abutting an AlN or AI(x)Ga(1-x)N interlayer that provides the driving force for the formation of the quantum dots.

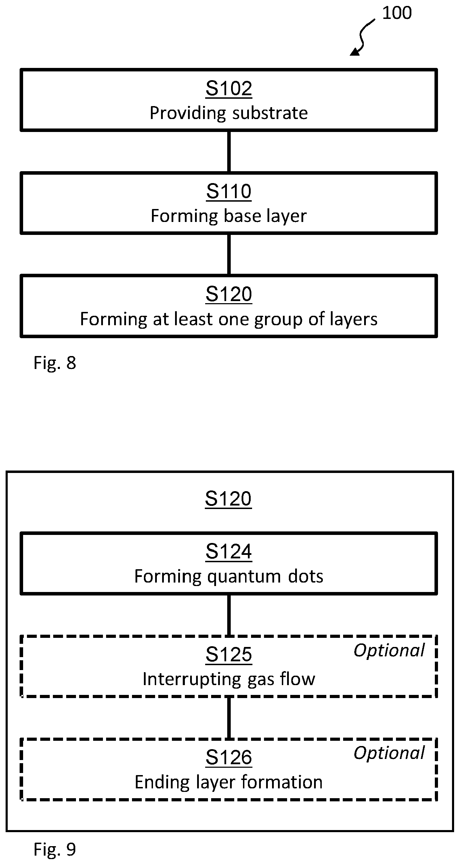

Fig. 8 shows a flow chart of a method 100 for producing the semiconductor structure 1. According to the method 100, a substrate 2 is first provided S102. The base layer 10 is then formed S110 above the substrate 2. Subsequently, at least one group of layers 20 is formed S120 above the base layer 10 by forming the first layer 21 and forming the second layer 22, wherein forming the at least one group of layers 20 comprises, for at least one of the at least one group of layers 20, forming S124 the quantum dots 24 of the first layer 21 by self-assembly. The above may be implemented by placing the substrate 2, e.g. a silicon substrate in the reactor cell of a metal-organic vapor phase epitaxy (MOVPE) system and supplying precursor gases at suitable pressures and temperatures to grow the layers of the semiconductor structure 1. Alternatively, the base layer 10, or parts of the base layer 10 may be formed before placing the substrate 2 in the MOVPE system. For example, the base layer 10, or parts of the base layer 10 may be formed by sputtering of AlN or AlGaN on the substrate 2.

Forming the quantum dots 24 of the first layer 21 may be done by Stranski-Krastanov growth. Thus, the material forming the quantum dots 24 may be grown lattice mismatched to the layer below, e.g. lattice mismatched to the base layer or lattice mismatched to a second layer 22 of a preceding group of layers.

The step of forming S120 the at least one group of layers may, in addition to forming S124 the quantum dots 24, comprise one or more optional steps, as seen in Fig. 9.

As an example, a gas flow may be interrupted S125 for at least 5 seconds between forming the first layer 21 and forming the second layer 22, wherein the gas flow is a gas flow comprising nitrogen. Thus, a gas flow of nitrogen gas or ammonia may be interrupted for at least 5 seconds. The interrupted gas flow may be the entire gas flow of group V supply in the MOVPE reactor cell. Alternatively, the interrupted gas flow may be part of the entire gas flow of group V supply in the MOVPE reactor cell.

As another example, layer formation of the first layer 21 may be ended S126 based on a photoluminescence signal from the quantum dots 24 of the first layer 21. The photoluminescence signal may herein be acquired by illuminating the semiconductor structure 1 with light, e.g. laser light and collecting the photoemission from the quantum dots 24. The photoemission may herein be collected e.g. with a microscope objective, e.g. a microscope objective with long working distance. The collected light may be sent to a spectrometer whereby a spectrum may be acquired. Each quantum dot may give rise to at least one spectral peak which may be characteristic of the quantum dot size. A high energy (short spectral wavelength) spectral peak may indicate a small quantum dot. A low energy (long spectral wavelength) spectral peak may indicate a large quantum dot. Many quantum dots may contribute to the photoluminescence signal. However, the same principles as for a single quantum dot may apply. If the photoluminescence signal is centered around a short spectral wavelength, most quantum dots may be considered to be high energy quantum dots, i.e. small quantum dots. As the quantum dots grow bigger the spectrum of the photoluminescence signal may drift towards longer wavelengths. When the spectral peak of the photoluminescence signal is centered around a threshold value, this may be seen as an indication that the quantum dots 24 have reached a threshold size and the layer formation of the first layer 21 may be ended S126. When the spectral peak of the photoluminescence signal has a certain width and/or position, this may be seen as an indication that the quantum dots 24 have reached a threshold density and the layer formation of the first layer 21 may be ended S126.

As previously described, quantum dots 24 may be combined with a base layer 10 comprising pillars. Thus, forming S110 the base layer 10 may comprise forming a primary layer 11, the primary layer 11 comprising pillars 14 extending in a direction perpendicular to the substrate 2. For example, semiconductor material may be deposited on the substrate 2 and then lithographically patterned and etched to form pillars 14. A secondary layer 12 may then be formed, the secondary layer 12 being configured to laterally enclose the pillars 14 of the primary layer 11. The material for the primary layer 11 may e.g. grown by MOVPE. Alternatively, the material for the primary layer 11 may be sputtered semiconductor material. The material for the secondary layer 12 may e.g. be epitaxially grown semiconductor material, e.g. grown by MOVPE.

The primary layer 11 may be formed in an atmosphere comprising hydrogen and nitrogen. The secondary layer 12 may be formed in an atmosphere comprising nitrogen. The primary layer 11 may be formed in an atmosphere comprising hydrogen and nitrogen with a hydrogen to nitrogen molar ratio between 2 to 1 and 1 to 2. In particular, said primary layer may be formed in an atmosphere comprising hydrogen and nitrogen with a hydrogen to nitrogen molar ratio of 1 to 1. The above may be applicable in the case where the material for the primary layer 11 is grown by MOVPE as well as in the case where the material for the primary layer 11 is sputtered.

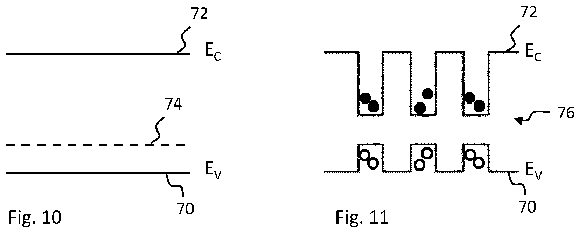

As previously discussed, the quantum dots 24 may form recombination centers. Thus, quantum dots 24 may replace iron dopants as recombination centers. Figs 10-11 illustrate the difference between iron dopants and quantum dots 24.

Fig. 10 schematically illustrates a band diagram of a semiconductor, e.g. GaN, doped with iron. The figure illustrates the valence band 70 and the conduction band 72. The figure further illustrates the energy levels 74 of the iron dopants. Iron dopant in the crystal structure of GaN may create gallium vacancy states as deep donor states 0.70 eV above the valence band 70.

Fig. 11 schematically illustrates a band diagram of a semiconductor, e.g. GaN, comprising an energy structure 76 of quantum dots 24. In the figure, an energy structure 76 of three quantum dots 24 may be seen. As illustrated, the quantum dots 24 may form potential wells in both the valence band 70 and the conduction band 72. There may be holes in the potential wells of the valence band 70, as illustrated. Similarly, there may be electrons in the potential wells of the conduction band 72, as illustrated. Thus, by the quantum dots 24 having a band gap in the middle of the band gap of GaN, quantum dots 24 present states that may act as both as acceptors and a donors.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A semiconductor structure (1), comprising:
a substrate (2);
a base layer (10), the base layer (10) comprising an AlGaN layer, the base layer (10) being arranged above the substrate (2);
at least one group of layers (20), the at least one group of layers (20) being arranged above the base layer (10), wherein each of the at least one group of layers (20) comprises:
a first layer (21), the first layer (21) being a layer of InGaN and comprising quantum dots (24);
a second layer (22), the second layer (22) being a layer of InGaN, the second layer (22) being arranged on and above the first layer (21), wherein the second layer (22) laterally encloses the quantum dots (24) of the first layer (21), wherein a material composition of the InGaN of the second layer (22) is different from a material composition of the InGaN of the first layer (21).

2. The semiconductor structure (1) according to claim 1, wherein the at least one group of layers (20) comprises a plurality of groups of layers (20).

3. The semiconductor structure (1) according to claim 1 or 2, wherein, for at least one of the at least one group of layers (20),
an indium content in the InGaN of the first layer (21) is lower than an indium content of the InGaN of the second layer (22).

4. The semiconductor structure (1) according to any one of the preceding claims, wherein, for at least one of the at least one group of layers (20),
a material composition of the InGaN of the first layer (21) is InₓGa₁₋ₓN, wherein x is a number in the range 0.1 to 0.2 or 0.2-0.4.

5. The semiconductor structure (1) according to any one of the preceding claims, wherein, for at least one of the at least one group of layers (20),
a density of the quantum dots (24) of the first layer (21) is between 10⁹ cm⁻² and 10¹³ cm⁻².

6. The semiconductor structure (1) according to any one of the preceding claims, wherein, for at least one of the at least one group of layers (20),
a density of the quantum dots (24) of the first layer (21) is at least 10¹⁰ cm⁻².

7. The semiconductor structure (1) according to any one of the preceding claims, wherein, for at least one of the at least one group of layers (20),
a lattice constant of material in the first layer (21) is at least 0.5 % larger than a lattice constant of material in a layer directly below said first layer (21) at room temperature.

8. The semiconductor structure (1) according to any one of the preceding claims, wherein, for at least one of the at least one group of layers (20),
a lattice constant of material in the first layer (21) is at least 0.5 % larger than a lattice constant of material in the second layer (22) at room temperature.

9. The semiconductor structure (1) according to any one of the preceding claims, wherein the base layer (10) comprises:
a primary layer (11), the primary layer (11) being a layer of semiconductor material, the primary layer (11) comprising pillars (14) extending in a direction perpendicular to the substrate (2);
a secondary layer (12), the secondary layer (12) being a layer of semiconductor material, wherein the secondary layer (12) is configured to laterally enclose the pillars (14) of the primary layer (11).

10. A method (100) for producing the semiconductor structure (1) of any one of the preceding claims, the method (100) comprising:
providing (S102) the substrate (2);
forming (S110) the base layer (10) above the substrate (2);
forming (S120) the at least one group of layers (20) above the base layer (10) by forming the first layer (21) and forming the second layer (22), wherein forming the at least one group of layers (20) comprises, for at least one of the at least one group of layers (20), forming (S124) the quantum dots (24) of the first layer (21) by self-assembly.

11. The method (100) according to claim 10, wherein forming (S120) the at least one group of layers (20) comprises, for at least one of the at least one group of layers (20), forming (S124) the quantum dots (24) of the first layer (21) by Stranski-Krastanov growth.

12. The method (100) according to claim 10 or 11, wherein forming (S120) the at least one group of layers (20) comprises, for at least one of the at least one group of layers (20),
interrupting (S125) a gas flow for at least 5 seconds between forming the first layer (21) and forming the second layer (22), wherein the gas flow is a gas flow comprising nitrogen.

13. The method (100) according to any one of claims 10-12, wherein forming (S120) the at least one group of layers (20) comprises, for at least one of the at least one group of layers (20),
ending (S126) layer formation of the first layer (21) based on a photoluminescence signal from the quantum dots (24) of the first layer (21).

14. The method (100) according to any one of claims 10-13, wherein forming (S110) the base layer (10) comprises
forming a primary layer (11), the primary layer (11) being a layer of semiconductor material, the primary layer (11) comprising pillars (14) extending in a direction perpendicular to the substrate (2);
forming a secondary layer (12), the secondary layer (12) being a layer of semiconductor material, wherein the secondary layer (12) is configured to laterally enclose the pillars (14) of the primary layer (11);
wherein said primary layer (11) is formed in an atmosphere comprising hydrogen and nitrogen; and/or wherein said secondary layer (12) is formed in an atmosphere comprising nitrogen.

15. The method (100) according to any one of claims 10-14, comprising reactive sputtering of the base layer and as an interlayer (10) of AlN or AlGaN.

16. The method (100) according to claim 15, wherein said interlayer (10) has a thickness of 10-30 nm.
